# EUROPEAN PATENT APPLICATION

(11) **EP 1 903 122 A1**
(43) Date of publication of application: **26.03.2008**
(21) Application number: 06768031.4
(22) Date of filing: 10.07.2006
(51) Int. Cl.: C23C 14/34, B22F 9/04, C22C 1/04, C22C 28/00

(54) **SPUTTERING TARGET FOR THE FORMATION OF PHASE-CHANGE FILMS AND PROCESS FOR THE PRODUCTION OF THE TARGET**

(30) Priority: 11.07.2005 JP 2005201246; 29.06.2006 JP 2006179153
(71) Applicant: MITSUBISHI MATERIALS CORPORATION, Chiyoda-ku, Tokyo 100-8117 (JP)
(72) Inventor: NONAKA, Sohei, Mitsubishi Material Corporation, Sanda-shi, Hyogo 669-1339 (JP); KINOSHITA, Kei, Mitsubishi Material Corporation, Sanda-shi, Hyogo 669-1339 (JP)
(74) Representative: Gille Hrabal Struck Neidlein Prop Roos
(86) International application number: PCT/JP2006/313669
(87) International publication number: WO 2007/007704

(57) **Abstract**

The present invention provides a sputtering target for forming a phase-change film which generates few particles in sputtering and a method for manufacturing the same. The target of the invention has a composition containing in terms of atomic %, 20.2 to 24.2% of Ge, 20.2 to 24.2% of Sb, and the remainder including Te and inevitable impurities, and having a microstructure in which a Ge₂Sb₂Te₅ phase having a hexagonal structure accounts for 90% or more in terms of mass %, and this target can be manufactured by subjecting a raw alloy powder to pressure sintering, and the raw alloy powder is obtained either by heat-treating an alloy ingot having the above composition and grinding the resulting alloy ingot, or by grinding the alloy ingot and heat-treating the obtained ground alloy powder and then pulverizing the alloy powder.

## Description

### TECHNICAL FIELD

The present invention relates to a sputtering target for forming a phase-change film and a method for manufacturing the sputtering target, and this sputtering target for forming a phase-change film generates few particles at the time of sputtering and allows formation of phase-change recording films for phase-change recording media such as DVD-RAM and semiconductor nonvolatile memories (Phase-change RAM (PCRAM)) at high yields.

### BACKGROUND ART

Phase-change materials are used as recording films in phase-change recording media, such as DVD-RAM, and semiconductor nonvolatile memories (Phase-change RAM(PCRAM)) and heat induced by laser beam emission or Joule heat causes reversible phase changes between crystalline and noncrystalline phases, and the difference in the reflectivities, or in the electrical resistivities, between the crystalline and noncrystalline phases are related to one and zero to realize nonvolatile memories. As one of such phase-change materials, a phase-change film has been known which has a composition containing, in terms of atomic %, 20.2 to 24.2% of Ge, 20.2 to 24.2% of Sb, and the remainder including Te and inevitable impurities. This phase-change film is formed by sputtering using a sputtering target having about the same element composition as the phase-change film. The sputtering target is manufactured by melting and casting to obtain an alloy ingot having a composition containing, in terms of atomic %, 20.2 to 24.2% of Ge, 20.2 to 24.2% of Sb, and the remainder including Te and inevitable impurities, grinding the alloy ingot to obtain a raw alloy powder, and subjecting the raw alloy powder to pressure sintering at a temperature of 450°C or higher and lower than 630°C by a method such as hot pressing or hot-isostatic pressing (e.g., Patent Document 1).
Patent Document 1: Japanese Unexamined Patent Application, First Publication No. H05-311423

### DISCLOSURE OF THE INVENTION

### Problems to be Solved by the Invention

Even when melting and casting to have a composition containing 20.2 to 24.2% of Ge, 20.2 to 24.2% of Sb and the remainder including Te and inevitable impurities at the time of preparation, the primary crystal of GeTe precipitates first from the melt during cooling after casting, which shifts the composition of the remaining liquid toward Sb rich. Further cooling results in precipitation of a Ge₂Sb₂Te₅ phase and other phases such as a GeSb₂Te₄ phase which are richer in Sb than Ge₂Sb₂Te₅ phase. Therefore, a plurality of phases having different compositions exist in the matrix of the ingot produced by ordinary melting and casting, and a plurality of phases having different compositions exist in the matrix of the conventional raw alloy powder produced by grinding the ingot in which the plurality of phases having different compositions exist. As a result, a plurality of different phases exist in the matrix of the target produced by pressure sintering the conventional raw alloy powder containing the plurality of phases having different compositions in the matrix by a method such as vacuum hot pressing or hot isostatic pressing, even though the phases other than the Ge₂Sb₂Te₅ phase are reduced to some extent by reactions during sintering.

Each of the plurality of different phases has a different electrical conductivity, and therefore, abnormal electrical discharge is caused when sputtering is carried out using a target in which a plurality of different phases having different electrical conductivities exist in the matrix. In addition, the surface and the vicinity of the surface of the target are heated to several hundred degrees Celsius by plasma heating during the sputtering, which induces reactions among the phases having different compositions in the target microstructure during discharge and causes abnormal electrical discharge and particle generation.

The present invention provides a sputtering target which generates few particles and a method for manufacturing the same.

### Means for Solving the Problems

The present inventors have conducted research to solve the problems. The following findings of the research are obtained.
(a) when melting and casting to obtain an alloy ingot having a composition containing 20.2 to 24.2% of Ge, 20.2 to 24.2% of Sb, and the remainder including Te and inevitable impurities, and heat-treating the alloy ingot at a temperature from 320 to 600°C in a vacuum atmosphere or in an inert gas atmosphere, a plurality of phases such as the GeTe phase and GeSb₂Te₄ phase, which are different from the principal Ge₂Sb₂Te₅ phase, are reduced, resulting in a single phase microstructure of a Ge₂Sb₂Te₅ phase having a hexagonal crystal structure. A raw alloy powder obtained by grinding the heat-treated alloy ingot has a single phase microstructure in which the Ge₂Sb₂Te₅ phase having a hexagonal crystal structure accounts for the majority and phases such as the GeTe phase and GeSb₂Te₄ phase are almost annihilated. In a target obtained by subjecting the raw alloy powder to pressure sintering at a temperature of 450°C or higher and lower than 630°C using a method such as vacuum hot pressing or hot isostatic pressing, the Ge₂Sb₂Te₅ phase having a hexagonal crystal structure accounts for 90% or more in terms of % by mass, when quantitatively measured by X-ray diffraction. When sputtering is conducted using this target, generation of particles is drastically reduced during sputtering.
(b) melting and casting is conducted to obtain an alloy ingot having a composition containing 20.2 to 24.2% of Ge, 20.2 to 24.2% of Sb, and the remainder including Te and inevitable impurities, and the obtained alloy ingot is ground to produce an alloy powder. The obtained alloy powder is heat-treated at a temperature from 320 to 600°C in a vacuum atmosphere or in an inert gas atmosphere, and the heat-treated alloy powder is subjected to re-grinding to obtain a raw alloy powder. The raw alloy powder has an almost single phase microstructure in which the Ge₂Sb₂Te₅ phase having a hexagonal crystal structure accounts for the majority with the phases such as the GeTe phase and GeSb₂Te₄ phase being almost annihilated. In a target obtained by subjecting the raw alloy powder to pressure sintering at a temperature of 450°C or higher and lower than 630°C using a method such as vacuum hot pressing or hot isostatic pressing, the Ge₂Sb₂Te₅ phase having a hexagonal crystal structure accounts for 90% or more in terms of % by mass, when quantitatively measured by X-ray diffraction, even when the raw alloy powder is mixed with less than 15% of conventional powders, because phases other than the Ge₂Sb₂Te₅ phase are annihilated during sintering. When sputtering is conducted using this target, generation of particles is drastically reduced during sputtering.
(c) melting and casting is conducted to obtain an alloy ingot having a composition containing 20.2 to 24.2% of Ge, 20.2 to 24.2% of Sb, and the remainder including Te and inevitable impurities, and the obtained alloy ingot is ground to produce an unheat-treated conventional raw alloy powder. The raw alloy powder obtained by either (a) or (b) is mixed with 15% by mass or less of the conventional raw alloy powder to obtain a mixed raw powder, and the mixed raw powder is subjected to pressure sintering at a temperature of 450°C or higher and lower than 630°C using a method such as vacuum hot pressing or hot isostatic pressing to obtain a target. In the obtained target, the Ge₂Sb₂Te₅ phase having a hexagonal crystal structure accounts for 90% or more in terms of % by mass, when quantitatively measured by X-ray diffraction, even when the raw alloy powder is mixed with less than 15% of the conventional powders, because phases other than the Ge₂Sb₂Te₅ phase are annihilated during sintering. Furthermore, the density is increased; thereby, mechanical strength is improved. Few particles are generated during sputtering, and any practical problem is not caused.

The present invention has been made based on the above research findings and has the following features.
(1) a sputtering target for forming a phase-change film, having a composition including, in terms of atomic %, 20.2 to 24.2% of Ge, 20.2 to 24.2% of Sb, and the remainder including Te and inevitable impurities, and having a microstructure in which a Ge₂Sb₂Te₅ phase having a hexagonal structure accounts for 90% or more in terms of mass % when analyzed quantitatively by X-ray diffraction.
(2) a method for manufacturing a sputtering target for forming a phase-change film which generates few particles, the method includes: melting and casting to obtain an alloy ingot having a composition containing, in terms of atomic %, 20.2 to 24.2% of Ge, 20.2 to 24.2% of Sb, and the remainder including Te and inevitable impurities; heat-treating the alloy ingot at a temperature from 320 to 600°C in a vacuum atmosphere or in an inert gas atmosphere; grinding the heat-treated alloy ingot to obtain a raw alloy powder; and subjecting the raw alloy powder to pressure sintering.
(3) a method for manufacturing a sputtering target for forming a phase-change film which generates few particles, the method includes: melting and casting to obtain an alloy ingot having a composition containing, in terms of atomic %, 20.2 to 24.2% of Ge, 20.2 to 24.2% of Sb, and the remainder including Te and inevitable impurities; grinding the alloy ingot to prepare an alloy powder; heat-treating the obtained alloy powder at a temperature from 320 to 600°C in a vacuum atmosphere or in an inert gas atmosphere; pulverizing the heat-treated alloy powder to obtain raw alloy powder; and subjecting the raw alloy powder to pressure sintering.
(4) a method for manufacturing a sputtering target for forming a phase-change film which generates few particles, the method includes: mixing 15% by mass or less of an unheat-treated conventional raw alloy powder with the raw alloy powder obtained in the method according to (2) to obtain a mixed raw powder, the unheat-treated conventional raw alloy powder is obtained by melting and casting to obtain an alloy ingot having a composition containing, in terms of atomic %, 20.2 to 24.2% of Ge, 20.2 to 24.2% of Sb, and the remainder including Te and inevitable impurities and grinding the alloy ingot; and subjecting the mixed raw powder to pressure sintering.
(5) a method for manufacturing a sputtering target for forming a phase-change film which generates few particles, the method includes: mixing 15% by mass or less of a conventional raw alloy powder with the raw alloy powder obtained in the method according to (3) to obtain a mixed raw powder, the conventional raw alloy powder is obtained by melting and casting to obtain an alloy ingot having a composition containing, in terms of atomic %, 20.2 to 24.2% of Ge, 20.2 to 24.2% of Sb, and the remainder including Te and inevitable impurities and grinding the alloy ingot; and subjecting the mixed raw powder to pressure sintering.

The reasons for limiting the heat-treatment temperature from 320 to 600°C are as follows. At temperatures below 320°C, since elements do not diffuse sufficiently, the homogenization and formation of the single phase microstructure do not occur, therefore, it is not preferable. While at temperatures higher than 600°C, the Sb rich phases having lower melting points tend to melt, and when they melt, the phases are separated during cooling. Therefore, the object of homogenization cannot be achieved, and it is not preferable. A more preferable range of the heat treatment temperature is from 450 to 590°C. For the heat treatment, it is preferable to make the holding time longer, preferably 2 hours or longer and more preferably 5 hours or longer. In addition, in order to prevent oxidation of each element, it is required to carry out the heat treatment in an inert gas atmosphere, such as argon gas or nitrogen gas, or in a vacuum.

The raw alloy powder thus prepared is pressure sintered, preferably, by a vacuum hot pressing method or by a hot isostatic pressing method and the reasons for limiting to a temperature of 450°C or higher and lower than 630°C is as follows. At temperatures lower than 450°C, the sintering becomes insufficient, and therefore it is not preferable. At temperatures higher than 630°C, the Ge₂Sb₂Te₅ phase that will become the principal phase melts, and therefore it is not preferable. Amore preferable range of the sintering temperature is from 550 to 620°C. For the vacuum hot pressing method or for the hot isostatic pressing method, it is preferable to make the holding time longer, preferably 30 minutes or longer, and more preferably 1 hour or longer. In addition, the pressure for the vacuum hot pressing, or the hot isostatic pressing, is required to be 15 MPa or higher, and more preferably is 20 MPa or higher.

The raw alloy powder according to the present invention may be mixed with a small amount of a conventional unheat-treated raw alloy powder to provide a mixed raw material powder, and this mixed raw material powder may be subjected to vacuum hot pressing or hot isostatic pressing. Even by this process, a target generating few particles can be manufactured. However, in the case in which the additive amount of the unheat-treated conventional raw alloy powder exceeds 15% by mass, the target made from the mixed raw powder generates an increased amount of particles, and therefore it is not preferable. As a result, the additive amount of the conventional raw alloy powder contained in the mixed raw powder is limited to 15% by mass or less.

Incidentally, since the composition containing 20.2 to 24.2% of Ge, 20.2 to 24.2% of Sb and the remainder including Te and inevitable impurities, is generally known as the composition of phase-change films and of the sputtering target for manufacturing the phase-change films, the explanations for the limitations are omitted.

### EFFECTS OF THE INVENTION

The sputtering target manufactured by the method according to the present invention generates few particles and allows the production of phase-change films at high yields, and thus can contribute significantly to the progression of the optical recording disk industry and new semiconductor memory industry.

### BRIEF DESCRIPTION OF THE DRAWINGS

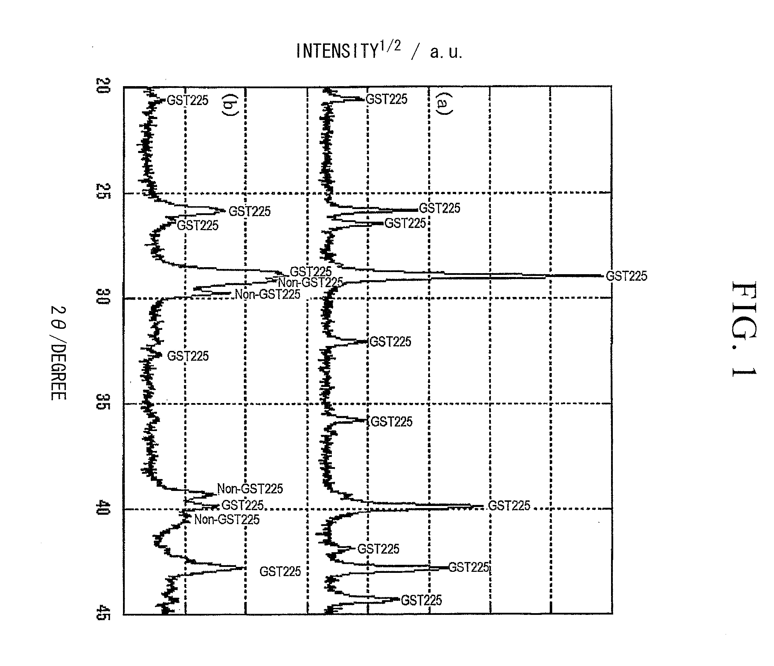

FIG. 1 is a graph obtained from X-ray diffraction of raw alloy powders.

### BEST MODE FOR CARRYING OUT THE INVENTION

### Examples 1 to 8 and Comparative Examples 1 to 3

The elemental raw materials Ge, Sb and Te were weighed, so as to form a composition consisting of Ge: 22.2 atomic%, Sb: 22.2 atomic% and the balance being Te. The composition was melted at a temperature of 800°C in an Ar atmosphere and was cast into alloy ingots. These alloy ingots were heat-treated at the temperatures shown in Table 1 and for holding times shown in Table 1, and the heat-treated alloy ingots were ground to produce raw alloy powders. The raw alloy powder prepared for Example 1 was subjected to X-ray diffraction. As shown in FIG. 1 (a), almost only the peaks of stable Ge₂Sb₂Te₅ phase (hexagonal crystal structure) were observed. (The peaks of the Ge₂Sb₂Te₅ phase are denoted as GST225 in FIG. 1)

The raw alloy powders, prepared for Examples 1 to 8 and Comparative Examples 1 to 3, were subjected to vacuum hot pressing under the pressures, at the temperatures and for the holding times shown in Table 1 to provide sintered bodies. The sintered bodies were machined into disk-shaped targets having a diameter of 152. 4 mm and a thickness of 6 mm. The sintered bodies remaining after the machining of the targets were cut into samples for X-ray diffraction. The samples were ground into powders having average particle diameters falling in the range from 5 to 20 µm. The obtained sample powders were subjected to quantitative analysis by X-ray diffraction under the following conditions, and it was found that the Ge₂Sb₂Te₅ phase having a hexagonal crystal structure accounts for 90% or more, in terms of % by mass, in the samples of Examples 1 to 8, while it accounts for less than 90%, in terms of % by mass, in the samples of Comparative Examples 1 to 3. Method of quantitative analyses by X-ray diffraction:
An MXP18VAHF manufactured by Bruker AXS was used for the X-ray diffraction measurement, and 2θ/θ scanning measurements were carried out using the optical system having the Bragg-Brentano focusing geometry. The measurement conditions were as follows.

Target: Cu
Characteristic X ray: Kα line (monochromated by a
counter-monochromator)
Tube voltage: 40 KV Tube current: 300 mA
Scanning method: Step scanning
2θ step = 0.02 degrees
Step time: 10 seconds/step

A preliminary measurement indicated that after sintering, the target made by the conventional method contained almost only two components of the Ge₂Sb₂Te₅ phase and GeSb₂Te₄ phase, and the mass percentage of the Ge₂Sb₂Te₅ phase was determined by the quantitative analysis of the two components, under the assumption that only those two phases exist in the target. The following describes the method.

Firstly, powders respectively consisting only of the Ge₂Sb₂Te₅ phase and GeSb₂Te₄ phase were weighed and mixed to prepare five standard samples having mass ratios of 0:100, 25:75, 50:50, 75:25 and 100:0. Incidentally, the powder consisting only of Ge₂Sb₂Te₅ and the powder consisting only of GeSb₂Te₄ for the standard samples were prepared as follows. The elemental materials Ge, Sb and Te were weighed and mixed in the atomic ratios of 2: 2: 5 and 1: 2: 4, respectively, and were melted at a temperature of 800°C in an Ar atmosphere. The melts thus obtained were cast into alloy ingots, and the alloy ingots were heat-treated at 580°C in the case of Ge₂Sb₂Te₅, and at 560°C in the case of GeSb₂Te₄, for 48 hours. The alloy ingots were ground and then were sintered by vacuum hot pressing at 580°C in the case of Ge₂Sb₂Te₅, and at 560°C in the case of GeSb₂Te₄, for a holding time of 10 hours for further homogenization. The sintered bodies were ground again into powders having average diameters falling in the range from 5 to 20 µm. From the X-ray diffraction measurements of these powders, only the Ge₂Sb₂Te₅ phase or GeSb₂Te₄ phase was detected respectively. Therefore, these were provided as standard sample powders.

Next, the (004) peak of the Ge₂Sb₂Te₅ phase and the (009) peak of the GeSb₂Te₄ phase were measured to determine their integrated intensities. Incidentally, the measurement range for each peak was as follows.
(004) peak of Ge₂Sb₂Te₅ phase: 2θ = 20.0° to 21.2°
(009) peak of GeSb₂Te₄ phase: 2θ = 18.8° to 20.0°

The integrated intensities were determined by separating peaks after smoothing and background removal. The software used for the following analysis and calculation of concentrations were "JADE 6.0" from Materials Data, Inc. (MDI) and Microsoft Excel.

The smoothing was carried out by the Savitzky-Golay method. In the JADE 6.0 setting, a parabolic filter was used as the filter and the point number was set to 9 point. In the background removal of JADE 6.0, a three-dimensional polynomial equation was used as the equation for the approximation of the background, the point number assigned as the background was the second value from the smallest, the threshold value for removing specified points deviating significantly from the background was set to 3, and the positioning of the background to be drawn away from the set-point was set to σ = 0.2.

The peak separation in JADE 6.0 was carried out by the condition settings described below.
Fitting function: Pearson VII
Kα2 line (presence or absence): Presence
Asymmetry (presence or absence): Absence
Initial half-width: 0.15 degrees
Initial peak position: The peak search results were used.
Background processing: Linear

A calibration curve was prepared based on the results of the above measurements for the standard samples with known compositions by plotting the integrated intensities along the vertical axis and the mass percentage concentrations along the horizontal axis.

Next, the (004) peak of the Ge₂Sb₂Te₅ phase and the (009) peak of the GeSb₂Te₄ phase were measured for the powder samples prepared for Examples 1 to 8 and Comparative Examples 1 to 3 to determine their integrated intensities, and the concentrations of the respective phases were calculated using the calibration curve prepared above.

Incidentally, in the above X-ray measurements, each powder was taken out of a sample holder and put back into the holder for remeasurement, after a measurement had been made once on each of the standard samples and powder target samples; the procedure was repeated three times for each sample; and the average of the three values was taken as the measured value. In the case that the total of the mass concentrations measured for the Ge₂Sb₂Te₅ phase and GeSb₂Te₄ phase does not match with 100%, the total was normalized to 100% to determine the mass concentration of each phase. In other words, the result was recalculated as "the mass concentration of each phase" = ("the mass concentration measured for each phase"/"the total of the mass concentrations measured for the phases) × 100.

The targets prepared for Examples 1 to 8 and Comparative Examples 1 to 3 were bonded to copper backing plates, and were installed in a sputtering apparatus. The targets were pre-sputtered under the following conditions for 1 hour to remove the machined layers on the target surfaces:
Ultimate vacuum pressure: 5 × 10⁻⁵ Pa;
Sputtering electric power: 120 W;
Sputtering gas (Ar gas) pressure: 1.0 Pa;
Distance between target and substrate: 70 mm; and
Substrate heating: None.

And then, the chamber was vented once to the atmosphere for the cleaning of parts inside the chamber, such as shield parts, and evacuated again to a predetermined vacuum. The targets were further pre-sputtered for 1 hour under the same conditions as described above to remove adsorbates and oxides from the atmosphere on the target surfaces, and then phase-change films with a 100 nm thickness were deposited onto 25 pieces of 6 inch wafers. The number of particles not smaller than 0.2 µm was counted for each of the deposited wafers using a commercially available particle inspection apparatus, and the average particle count of the 25 wafers is shown in Table 1.

### Conventional Example 1

The elemental raw materials Ge, Sb and Te were weighed, so as to form a composition consisting of Ge: 22.2 atomic%, Sb: 22.2 2 atomic% and the balance being Te, The composition was melted at a temperature of 800°C in an Ar atmosphere and was cast into an alloy ingot. The alloy ingot was ground into an alloy powder. The raw alloy powder prepared for the conventional example was subjected to X-ray diffraction. As shown in FIG. 1(b), peaks of the non-Ge₂Sb₂Te₅ phases were observed in addition to the peaks of the stable Ge₂Sb₂Te₅ phase (hexagonal crystal structure). (The peaks of the Ge₂Sb₂Te₅ phase are denoted as GST225, and the peaks of the other phases are denoted as Non-GST225 in FIG. 1).

The alloy powder was subjected to vacuum hot pressing under the pressure, at the temperature and for the holding time shown in Table 1 to provide a sintered body. The sintered body was machined into a disk-shaped target having a diameter of 152.4 mm and a thickness of 6 mm. The sintered body remaining after the machining of the target was cut into a sample for X-ray diffraction. The sample was ground into a powder having an average particle diameter falling in the range from 5 to 20 µm. This sample powder was subjected to quantitative analysis by X-ray diffraction in a similar manner, and it was found that the Ge₂Sb₂Te₅ phase having a hexagonal crystal structure accounts for less than 90% in terms of % by mass.

The target was bonded to a copper backing plate, and was installed in a sputtering apparatus. The target was pre-sputtered under the following conditions for 1 hour to remove the machined layer on the target surface:
Ultimate vacuum pressure: 5 × 10⁻⁵Pa;
Sputtering electric power: 120 W;
Sputtering gas (Ar gas) pressure: 1.0 Pa;
Distance between target and substrate: 70 mm; and
Substrate heating: None.

And then, the chamber was vented once to the atmosphere for the cleaning of parts inside the chamber, such as shield parts, and evacuated again to a predetermined vacuum. The target was further pre-sputtered for 1 hour under the same conditions as described above to remove adsorbates and oxides from the atmosphere on the target surface, and then phase-change films with a 100 nm thickness were deposited onto 25 pieces of 6 inch wafers. The number of particles not smaller than 0.2 µm was counted for each of the deposited wafers using a commercially available particle inspection apparatus, and the average particle count of the 25 wafers is shown in Table 1.

**Table 1**

| Type | | Heat-treatment conditions of ingot | | Vacuum hot pressing conditions | | | Density of sintered body (g/cm³) | Concentration of Ge₂Sb₂Te₅ phase (% by mass) | Number of particles |
|---|---|---|---|---|---|---|---|---|---|
| | | Temperature | Holding time | Pressure (MPa) | Temperature (°C) | Holding time | | | |
| Examples | 1 | 320 | 24 | 25 | 580 | 4 | 6.30 | 91.5 | 48 |
| | 2 | 450 | 24 | 25 | 580 | 4 | 6.29 | 93.8 | 30 |
| | 3 | 580 | 24 | 25 | 580 | 4 | 6.26 | 97.6 | 12 |
| | 4 | 600 | 24 | 25 | 580 | 4 | 6.28 | 99.1 | 15 |
| | 5 | 580 | 40 | 25 | 450 | 4 | 6.21 | 98.5 | 35 |
| | 6 | 580 | 20 | 25 | 500 | 4 | 6.24 | 97.5 | 24 |
| | 7 | 580 | 12 | 25 | 550 | 4 | 6.26 | 95.6 | 22 |
| | 8 | 580 | 10 | 25 | 620 | 4 | 6.28 | 95.1 | 25 |
| Comparative Examples | 1 | 610* | 24 | 25 | 580 | 4 | 6.30 | 87.5 | 105 |
| | 2 | 310* | 24 | 25 | 580 | 4 | 6.32 | 85.4 | 154 |
| | 3 | 580 | 1* | 25 | 580 | 4 | 6.31 | 84.9 | 190 |
| Conventional Example | | - | - | 25 | 580 | 2 | 6.34 | 83.6 | 245 |

| | | | | | | | | | |
|---|---|---|---|---|---|---|---|---|---|
| * The values marked by"*" are out of the scope of the present invention. | | | | | | | | | |

### Examples 9 to 16 and Comparative Examples 4 to 6

The elemental materials Ge, Sb and Te were weighed so as to form a composition consisting of Ge: 22.2 atomic%, Sb: 22.2 atomic% and the balance being Te. The composition was melted at a temperature of 800°C in an Ar atmosphere and was cast into alloy ingots. The alloy ingots were ground in the Ar atmosphere to prepare ground alloy powders. The obtained ground alloy powders were heat-treated at the temperatures shown in Table 2 for holding times shown in Table 2, and the heat-treated alloy powders were pulverized to produce raw alloy powders.

The raw alloy powders, prepared for Examples 9 to 16 and Comparative Examples 4 to 6, were subjected to vacuum hot pressing under the pressures, at the temperatures and for the holding times shown in Table 2 to provide sintered bodies. The sintered bodies were machined into disk-shaped targets having a diameter of 152.4 mm and a thickness of 6 mm. The sintered bodies remaining after the machining of the targets were cut into samples for X-ray diffraction. The samples were ground into powders having average particle diameters falling in the range from 5 to 20 µm. The sample powders were subjected to quantitative analysis by X-ray diffraction under the same conditions as in the cases of Examples 1 to 8 and Comparative Examples 1 to 3, and it was found that the Ge₂Sb₂Te₅ phase having a hexagonal crystal structure accounts for 90% or more, in terms of % by mass, in Examples 9 to 16, while it accounts for less than 90%, in terms of % by mass, in Comparative Examples 4 to 6.

The targets were bonded to copper backing plates, and were installed in a sputtering apparatus. The targets were pre-sputtered for 10 hours to remove the machined layers on the target surfaces under the same conditions as in the cases of Examples 1 to 8 and Comparative Examples 1 to 3, and then, the chamber was once vented to the atmosphere for the cleaning of parts inside the chamber, such as shield parts, and evacuated again to a predetermined vacuum. The targets were further pre-sputtered for 1 hour under the same conditions as in the cases of Examples 1 to 8 and Comparative Examples 1 to 3 to remove adsorbates and oxides from the atmosphere on the target surfaces, and then phase-change films with a 100 nm thickness were deposited onto 25 pieces of 6 inch wafers. The number of particles not smaller than 0.2 µm was counted for each of the deposited wafers using a commercially available particle inspection apparatus, and the average particle count of the 25 wafers is shown in Table 2.

**Table 2**

| Type | | Heat-treatment conditions of ground alloy powder | | Vacuum hot pressing conditions | | | Density of sintered body (g/cm³) | Concentration of Ge₂Sb₂Te₅ phase (% by mass) | Number of particles |
|---|---|---|---|---|---|---|---|---|---|
| | | Temperature | Holding time | Pressure (MPa) | Temperature (°C) | Holding time | | | |
| Examples | 9 | 320 | 24 | 25 | 580 | 4 | 6.30 | 90.8 | 45 |
| | 10 | 450 | 24 | 25 | 580 | 4 | 6.28 | 92.3 | 43 |
| | 11 | 580 | 24 | 25 | 580 | 4 | 6.30 | 96.1 | 25 |
| | 12 | 600 | 24 | 25 | 580 | 4 | 6.27 | 99.4 | 21 |
| | 13 | 560 | 5 | 25 | 450 | 4 | 6.15 | 93.5 | 66 |
| | 14 | 560 | 10 | 25 | 500 | 4 | 6.22 | 94.1 | 42 |
| | 15 | 560 | 15 | 25 | 550 | 4 | 6.29 | 94.3 | 30 |
| | 16 | 560 | 20 | 25 | 620 | 4 | 6.31 | 95.6 | 28 |
| Comparative Examples | 4 | 610* | 24 | 25 | 580 | 4 | 6.32 | 88.4 | 125 |
| | 5 | 310* | 24 | 25 | 580 | 4 | 6.31 | 83.5 | 249 |
| | 6 | 580 | 1* | 25 | 580 | 4 | 6.33 | 84.2 | 213 |

| | | | | | | | | | |
|---|---|---|---|---|---|---|---|---|---|
| * The values marked by"*" are out of the scope of the present invention. | | | | | | | | | |

### Examples 17 to 20 and Comparative Example 7

Mixed raw powders were prepared by mixing the raw alloy powder obtained for the conventional example with the raw alloy powder obtained for Example 3 in Table 1 at the ratios shown in Table 3. The mixed raw powders were subjected to vacuum hot pressing under pressures, at temperatures and for holding times shown in Table 3 to provide sintered bodies. The sintered bodies were machined into disk-shaped targets having a diameter of 152.4 mm and a thickness of 6 mm. The sintered bodies remaining after the machining of the target were cut into samples for X-ray diffraction. The samples were ground into powders having average particle diameters falling in the range from 5 to 20 µm. These sample powders were subjected to quantitative analysis by the X-ray diffraction under the same conditions as in the cases of Examples 1 to 8 and Comparative Examples 1 to 3, and it was found that the Ge₂Sb₂Te₅ phase having a hexagonal crystal structure accounts for 90% or more, in terms of mass percentage, in Examples 17 to 20, while it accounts for less than 90% in Comparative Example 7.

The targets were bonded to copper backing plates, and were installed in a sputtering apparatus. The targets were pre-sputtered for 5 hours to remove the machined layers on the target surfaces under the same conditions as in the cases of Examples 1 to 8 and Comparative Examples of 1 to 3. And then, the chamber was once vented to the atmosphere for the cleaning of parts inside the chamber, such as shield parts, and evacuated again to a predetermined vacuum. The targets were further pre-sputtered for 1 hour under the same conditions as in the cases of Examples 1 to 8 and Comparative Examples 1 to 3 to remove adsorbates and oxides from the atmosphere on the target surfaces, and then phase-change films with a 100 nm thickness were deposited onto 25 pieces of 6 inch wafers. The number of particles not smaller than 0.2 µm was counted for each of the deposited wafers using a commercially available particle inspection apparatus, and the average particle count of 25 wafers is shown in Table 3.

**Table 3**

| Type | | Composition of mixed raw powder (% by mass) | | Vacuum hot pressing conditions | | | Density of sintered body (g/cm³) | Concentration of Ge₂Sb₂Te₅ phase (% by mass) | Number of particles |
|---|---|---|---|---|---|---|---|---|---|
| | | Raw alloy powder produced by Conventional Example | Raw alloy powder produced by Example 3 | Pressure (MPa) | Temperature (°C) | Holding time (Hr) | | | |
| Examples | 17 | 5 | 95 | 25 | 580 | 2 | 6.35 | 97.1 | 18 |
| | 18 | 8 | 92 | 25 | 580 | 2 | 6.36 | 95.7 | 15 |
| | 19 | 11 | 89 | 25 | 580 | 2 | 6.35 | 93.6 | 30 |
| | 20 | 16 | 85 | 25 | 580 | 2 | 6.34 | 91.2 | 46 |
| Comparative Example 7 | | 17* | 83 | 25 | 580 | 2 | 6.35 | 87.6 | 109 |

| | | | | | | | | | |
|---|---|---|---|---|---|---|---|---|---|
| * The values marked by"*" are out of the scope of the present invention. | | | | | | | | | |

From the results shown in Tables 1 and 2, it is understood that the targets made from the raw alloy powders prepared for Examples 1 to 16 generate fewer particles compared to the target made from the raw alloy powder prepared for the Conventional Example in Table 1. It is also understood from the results shown in Table 3 that the targets of Examples 17 to 20, in which the raw alloy powders prepared for Example 1 were mixed with 15% by mass or less of the raw alloy powder prepared for Conventional Example, have improved densities and generate fewer particles. This indicates that a conventional raw alloy powder may be added up to 15% by mass in practice. However, it is understood from Comparative Examples 1 to 7 in Tables 1 to 3 that undesirable characteristics appear outside of the scope of the present invention.

## Claims

1. A sputtering target for forming a phase-change film, having a composition comprising, in terms of atomic %, 20.2 to 24.2% of Ge, 20.2 to 24.2% of Sb, and the remainder including Te and inevitable impurities, and having a microstructure in which a Ge₂Sb₂Te₅ phase having a hexagonal structure accounts for 90% or more in terms of mass % when analyzed quantitatively by X-ray diffraction.

2. A method for manufacturing a sputtering target for forming a phase-change film which generates few particles, the method comprising: melting and casting to obtain an alloy ingot having a composition containing, in terms of atomic %, 20.2 to 24.2% of Ge, 20.2 to 24.2% of Sb, and the remainder including Te and inevitable impurities; heat-treating the alloy ingot at a temperature from 320 to 600°C in a vacuum atmosphere or in an inert gas atmosphere; grinding the heat-treated alloy ingot to obtain a raw alloy powder; and subjecting the raw alloy powder to pressure sintering.

3. A method for manufacturing a sputtering target for forming a phase-change film which generates few particles, the method comprising: melting and casting to obtain an alloy ingot having a composition containing, in terms of atomic %, 20.2 to 24.2% of Ge, 20.2 to 24.2% of Sb, and the remainder including Te and inevitable impurities; grinding the alloy ingot to prepare an alloy powder; heat-treating the obtained alloy powder at a temperature from 320 to 600°C in a vacuum atmosphere or in an inert gas atmosphere; pulverizing the heat-treated alloy powder to obtain raw alloy powder; and subjecting the raw alloy powder to pressure sintering.

4. A method for manufacturing a sputtering target for forming a phase-change film which generates few particles, the method comprising: mixing 15% by mass or less of an unheat-treated conventional raw alloy powder with the raw alloy powder obtained in the method according to claim 2 to obtain a mixed raw powder, the unheat-treated conventional raw alloy powder being obtained by melting and casting to obtain an alloy ingot having a composition containing, in terms of atomic %, 20.2 to 24.2% of Ge, 20.2 to 24.2% of Sb, and the remainder including Te and inevitable impurities and grinding the alloy ingot; and subjecting the mixed raw powder to pressure sintering.

5. A method for manufacturing a sputtering target for forming a phase-change film which generates few particles, the method comprising: mixing 15% by mass or less of a conventional raw alloy powder with the raw alloy powder obtained in the method according to claim 3 to obtain a mixed raw powder, the conventional raw alloy powder being obtained by melting and casting to obtain an alloy ingot having a composition containing, in terms of atomic %, 20.2 to 24.2% of Ge, 20.2 to 24.2% of Sb, and the remainder including Te and inevitable impurities and grinding the alloy ingot; and subjecting the mixed raw powder to pressure sintering.
